# EUROPÄISCHE PATENTSCHRIFT

(11) **EP 1 614 009 B1**
(45) Veröffentlichungstag und Bekanntmachung des Hinweises auf die Patenterteilung: **02.08.2006**
(21) Anmeldenummer: 04727299.2
(22) Anmeldetag: 14.04.2004
(51) Int. Cl.: G03F 7/20, G03F 1/14

(54) **MASKIERUNGSANORDNUNG UND VERFAHREN ZUM HERSTELLEN VON INTEGRIERTEN SCHALTUNGSANORDNUNGEN**
MASKING ARRANGEMENT AND METHOD FOR PRODUCING INTEGRATED CIRCUIT ARRANGEMENTS
SYSTEME DE RESERVE ET PROCEDE POUR PRODUIRE DES CONFIGURATIONS DE CIRCUITS INTEGRES

(30) Priorität: 17.04.2003 DE 10317893
(43) Veröffentlichungstag der Anmeldung: 11.01.2006
(73) Patentinhaber: Infineon Technologies AG, 81669 München (DE)
(72) Erfinder: FREUND, Johannes, F-77133 Féricy (FR); STETTER, Michael, 82041 Deisenhofen (DE)
(74) Vertreter: Karl, Frank
(86) Internationale Anmeldenummer: PCT/EP2004/050524
(87) Internationale Veröffentlichungsnummer: WO 2004/092829

(56) Entgegenhaltungen:
- US-A1- 2001 026 894
- US-A1- 2002 176 065
- US-A1- 2003 017 631
- US-A1- 2003 039 928
- US-B1- 6 399 283

## Beschreibung

Die Erfindung betrifft eine Maskierungsanordnung, die ein Trägersubstrat enthält, beispielsweise ein Glassubstrat. Das Trägersubstrat trägt lithografische Muster, die Muster einer integrierten Schaltungsanordnung vorgeben, beispielsweise den Verlauf von Leitbahnen, die Lage von Kontaktlöchern oder sogenannten Vias bzw. die Lage von Dotierungsgebieten. Außerdem sind auf dem Trägersubstrat Hilfsmuster angeordnet, die für die Ausrichtung mehrerer Lithografieebenen erforderlich sind.

Aus der Japanischen Offenlegungsschrift JP 11329937 A ist ein Lithografiesystem bekannt, bei dem eine Retikelbibliothek von zwei Ausrichtungssystemen genutzt wird. Maßnahmen zur Anordnung von Schaltungsanordnungen auf den Retikeln oder Verfahren zur geschickten Herstellung insbesondere von Kleinserien sind nicht angegeben.

Es ist Aufgabe der Erfindung, eine einfache Maskierungsanordnung und ein einfaches Verfahren anzugeben, mit denen sich Schaltungsanordnungen mit geringem Fertigungsaufwand fertigen lassen. Außerdem sollen ein zugehöriger Datensatz und ein zugehöriges Programm angegeben werden.

Die auf die Maskierungsanordnung bezogene Aufgabe wird durch eine Maskierungsanordnung mit den im Patentanspruch 1 angegebenen Merkmalen gelöst. Weiterbildungen sind in den Unteransprüchen angegeben.

Die erfindungsgemäße Maskierungsanordnung enthält lithografische Muster, die in mindestens zwei Teilbereichen angeordnet sind, d.h. in zwei, drei oder mehr als drei Teilbereichen. Zum besseren Verständnis wird im Folgenden zunächst nur auf zwei Teilbereiche Bezug genommen. Jeder Teilbereich enthält Muster für jeweils mindestens eine integrierte Schaltungsanordnung, wobei in den Teilbereichen (16, 18) lithografische Muster für integrierte Schaltungsanordnungen (A, B) mit voneinander verschiedener Verdrahtung von Bauelementen angeordnet sind.

Die Erfindung geht von der Überlegung aus, dass es durch eine geschickte Anordnung von Hilfsmustern für die Ausrichtung mehrerer Lithografieebenen auf einfache Art möglich ist mit einem einzigen Maskensatz wahlweise eine von mindestens zwei verschiedene Schaltungsanordnungen in Massenfertigung ohne größere Einbußen von Siliziumfläche zu fertigen. Deshalb gibt es auf der erfindungsgemäßen Maskierungsanordnung zwei Arten von Hilfsmustern für die Ausrichtung mehrerer Lithografieebenen, nämlich:
- erste Hilfsmuster für die Ausrichtung mehrerer Lithografieebenen bei der Herstellung der einen Schaltungsanordnung ohne gleichzeitige Herstellung der anderen Schaltungsanordnung,
- zweite Hilfsmuster für die Ausrichtung mehrerer Lithografieebenen bei der Herstellung der anderen Schaltungsanordnung ohne gleichzeitige Herstellung der einen Schaltungsanordnung.

Auch wenn nur zwei Hilfsmuster vorhanden sind, lassen sich diese so kombinieren, dass beide Schaltungsanordnungen gleichzeitig hergestellt werden können, bspw. durch die Auswahl von Teilmustern.

Bei einer Weiterbildung gibt es außerdem:
- dritte Hilfsmuster für die Ausrichtung mehrerer Lithografieebenen bei der gleichzeitigen Herstellung beider Schaltungsanordnungen.
Durch die dritten Hilfsmuster ist keine Kombination von ersten Hilfsmustern und zweiten Hilfsmustern bei der gleichzeitigen Herstellung beider Schaltungsanordnungen erforderlich. Demzufolge sind keine Maßnahmen bezüglich der Kombination erforderlich, bspw. Programmiermaßnahmen.

Somit lassen sich bereits aufgrund der Kombination der beiden Arten von Hilfsmustern bzw. auf Grund der drei verschiedenen Arten von Hilfsmustern sowie auf Grund des Ausblendens von nicht zu belichtenden Teilbereichen bzw. des Auswählens eines zu belichtenden Teilbereiches oder mehrerer zu belichtender Teilbereiche auf andere Art drei verschiedene Fertigungsverfahren durchführen, nämlich die separate Fertigung der einen Schaltungsanordnungen oder der anderen Schaltungsanordnung sowie die gleichzeitige Fertigung beider bzw. aller Schaltungsanordnungen.

Insbesondere lassen sich auf der Maskierungsanordnung Muster zur Vorgabe von Schaltungsanordnungen für die Herstellung der Schaltungsanordnungen voneinander verschiedener Produkte anordnen. Im Stadium der Fertigungsvorbereitungsphase bzw. der Musterproduktionsphase für die Herstellung weniger Halbleiterscheiben ist bspw. eine gleichzeitige Herstellung aller auf der Maskierungsanordnung angeordneten Schaltungsanordnungen mit Hilfe der dritten Hilfsmuster angebracht, um das Design aller Schaltungsanordnungen zu überprüfen. In der Fertigungsphase für die Herstellung vieler Halbleiterscheiben, z.B. von mehr als 25 Halbleiterscheiben, ist es dagegen durch die ersten und zweiten Hilfsmuster ohne weiteres möglich, nur eine der beiden Schaltungsanordnungen zu fertigen, ohne dass auf einer Halbleiterscheibe Platz für die andere Schaltungsanordnung benötigt wird, weil die andere Schaltungsanordnung mit geringem Aufwand ausgeblendet werden kann. Die ersten Hilfsmuster bzw. die zweiten Hilfsmuster gewährleisten trotz des Ausblendens, dass die Ausrichtung bspw. für eine Halbleiterfertigung innerhalb sehr enger Toleranzen durchgeführt werden kann.

Bei einer Weiterbildung der Maskierungsanordnung sind die ersten Hilfsmuster an dem einen Teilbereich und vorzugsweise auch in dem einen Teilbereich angeordnet, vorzugsweise jedoch nicht an anderen Stellen. Die zweiten Hilfsmuster sind an dem anderen Teilbereich und vorzugsweise auch in dem anderen Teilbereich angeordnet, vorzugsweise jedoch nicht an anderen Stellen. Die dritten Hilfsmuster sind an einem von den beiden oder den mehreren Teilbereichen gebildeten Gesamtbereich und vorzugsweise auch innerhalb des Gesamtbereiches angeordnet. Demzufolge besteht ein enger räumlicher Zusammenhang zwischen dem Hilfsmuster und dem zugehörigen Bereich, für dessen Herstellung die betreffenden Hilfsmuster genutzt werden. Werden die Hilfsmuster an Trennbereichen angeordnet, an denen eine Halbleiterscheibe in mehrere Stücke bzw. Chips getrennt wird, so ist für die Hilfsmuster kein zusätzlicher Platzbedarf auf der Halbleiterscheibe erforderlich.

Bei einer anderen Weiterbildung sind insbesondere zwischen den Teilbereichen erste Hilfsmuster an anderen Orten als zweite Hilfsmuster angeordnet. Durch diese Maßnahme ist eine klare Zuordnung von Hilfsmustern zu einem Teilbereich gewährleistet. Alternativ oder zusätzlich sind die dritten Hilfsmuster an anderen Orten angeordnet als die ersten Hilfsmuster und die zweiten Hilfsmuster. Insbesondere werden die dritten Hilfsmuster näher am Rand der Maskierungsanordnung angeordnet als die ersten Hilfsmuster und die zweiten Hilfsmuster. Jedoch ist auch eine Mehrfachnutzung von Hilfsmustern möglich, z.B. als erste Hilfsmuster und als dritte Hilfsmuster.

Bei einer nächsten Weiterbildung werden die Hilfsmuster jeweils nahe von Ecken des ihnen zugeordneten Teilbereiches angeordnet. In den Ecken sind Abbildungsfehler erfahrungsgemäß am größten, so dass gerade dort die vorgegebenen Toleranzen eingehalten werden müssen. Liegen bei viereckigen Bereichen die Hilfsmuster in allen vier Ecken, so lassen sich Ausrichtungsverfahren auf einfache Art durchführen. Gibt es noch ein Hilfsmuster in der Mitte eines Bereiches, so kann die Ausrichtung erleichtert werden, beispielsweise beim Ermitteln der Lage einer Ebene, die durch alle Hilfsmuster verläuft. Liegen die Hilfsmuster an Stellen, die später auf Sägelinien projiziert werden, so bedeutet dies, dass die Hilfsmuster nahe der Ecken und außerhalb der betreffenden Bereiche liegen.

Bei einer nächsten Weiterbildung enthält ein Hilfsmuster jeweils mindestens eine Ausrichtmarke und mindestens eine Überlappungsmarke. Die Ausrichtmarke ermöglicht das Ausrichten der Maskierungsanordnung und einer bereits teilgefertigten integrierten Schaltungsanordnung auf einer Halbleiterscheibe. Beispielsweise ist die Ausrichtmarke kreuzförmig oder die Ausrichtmarke enthält mehrere zueinander parallel angeordnete Balken. Jedoch sind auch andere Formen von Ausrichtmarken möglich.

Die Überlappungsmarke ermöglicht eine Überprüfung des Versatzes einer Bestrahlung, die mit Hilfe der Maskierungsanordnung durchgeführt wird. Beispielsweise enthält die Überlappungsmarke mindestens einen Rahmen oder mindestens einen ausgefüllten oder freigelassenen rechteckförmigen bzw. quadratischen Bereich. Durch solche Überlappungsmarken lassen sich sogenannte Box-in-Box-Strukturen herstellen und zur Einhaltung Prüfung der Einhaltung von Toleranzen bei der Bestrahlung eines Resists nutzen. Ist der Versatz bei der Bestrahlung zu groß, so wird das Resist entfernt. Anschließend wird eine neue Resistschicht aufgebracht und bestrahlt bzw. belichtet.

Bei einer nächsten Weiterbildung enthält die Maskierungsanordnung außerdem Testmuster, die einem Teilbereich oder dem Gesamtbereich räumlich zugeordnet sind. Beispielsweise gibt es für jeden Bereich Testmuster, mit.denen zehn separate Schaltungsanordnungen hergestellt werden, die jeweils nur eine geringe Anzahl von Transistoren enthalten, z.B. einen oder weniger als einhundert Transistoren. Auch Testschaltungen ohne Transistoren werden eingesetzt. Eine geeignete Testschaltungsanordnung ist beispielsweise eine Oszillatorschaltung. Die Testmuster werden bei einer Ausgestaltung ebenfalls in Bereichen angeordnet, die auf Bereiche für Sägelinien projiziert werden. Auch eine Mehrfachnutzung von Testmustern ist möglich, bspw. von zwischen Teilbereichen angeordneten Testmustern als erste Testmuster und als zweite Testmuster oder von Testmustern in Randbereichen der Maskierungsanordnung als erste Testmuster und dritte Testmuster bzw. als zweite Testmuster und dritte Testmuster.

Bei einer nächsten Weiterbildung der Maskierungsanordnung bilden die ersten Hilfsmuster und die ersten Testmuster um den einen Teilbereich herum einen Rahmen. Die zweiten Hilfsmuster und die zweiten Testmuster bilden um den anderen Teilbereich herum einen anderen Rahmen. Ein dritter Rahmen wird durch die dritten Hilfsmuster und die dritten Teststrukturen um die beiden Rahmen herum gebildet. Durch die Anordnung der Hilfsmuster und Testmuster in Rahmen lassen sich Verwechslungen von Testmustern bei der Fertigung auf einfache Art vermeiden.

Die Maskierungsanordnung ist bei einer nächsten Weiterbildung eine Maske, die für eine 1:1-Bestrahlung verwendet wird, d.h. dass bei der Belichtung die auf der Maske angeordneten Muster in gleicher Größe in ein Resist übertragen werden. Bei einer alternativen Weiterbildung ist die Maskierungsanordnung ein sogenanntes Retikel für eine Bestrahlung mit einer Verkleinerung, z.B. im Verhältnis 4:1 oder 5:1. Zur Bestrahlung bzw. Belichtung wird sowohl bei einer Maske als auch bei einem Retikel ein Waferstepper oder ein Waferscanner eingesetzt.

Bei einer nächsten Weiterbildung der Maskierungsanordnung sind in einem Teilbereich Muster für mehrere Schaltungsanordnungen mit untereinander gleicher Verdrahtung von Bauelementen angeordnet. Beispielsweise befinden sich im ersten Teilbereich vier Steuerschaltkreise für jeweils einen Controller einer Festplatte gemäß einer Grundversion und im zweiten Teilbereich drei Steuerschaltkreise für jeweils einen Controller einer Version mit erweiterten Funktionen, z.B. mit einem integrierten flüchtigen Speicher. Durch diese Maßnahme ist bei der späteren Fertigung von Schaltkreisen eines ausgewählten Produktes eine gleichzeitige Belichtung mehrerer gleichartiger Schaltungsanordnungen möglich.

Bei einer anderen Weiterbildung der Maskierungsanordnung gibt es zwischen den beiden Teilbereichen Füllmuster, vorzugsweise erste Füllmuster und zweite Füllmuster. Die ersten Füllmuster umgeben bzw. umschließen bei einer Ausgestaltung den ersten Teilbereich, die ersten Hilfsmuster und die ersten Testmuster, jedoch nicht den zweiten Teilbereich, die zweiten Füllmuster, die zweiten Testmuster und die zweiten Hilfsmuster. Die zweiten Füllmuster umgeben bzw. umschließen bei einer Ausgestaltung den zweiten Teilbereich, die zweiten Hilfsmuster und die zweiten Testmuster. Jedoch werden der erste Teilbereich, die ersten Füllmuster, die ersten Hilfsmuster und die ersten Testmuster nicht von den zweiten Füllmuster umgeben. Die Füllstrukturen sind bspw. Balken oder Quadrate mit gleichmäßigen Abständen zueinander. Diese Weiterbildung geht von der Überlegung aus, dass bei der Auswahl der Schaltungsanordnungen eines bestimmten Produktes auf der Maskierungsanordnung eine scharfe Ausblendung der anderen Muster nur mit einem erhöhten aparativen Aufwand möglich ist. Wird kein erhöhter Aufwand betrieben, so gibt es Überschneidungsbereiche, in denen sich jedoch auf einfache Art und Weise die Füllmuster anordnen lassen, so dass diese Überschneidungsbereiche weniger störend sind. Die Füllbereiche sind insbesondere bei fortgeschrittenen CMOS-Technologien (Complementary Metal Oxide Semiconductor) mit minimalen Strukturbreiten kleiner als 0,35 oder 0,25 Mikrometer auch dazu geeignet, eine den Herstellungsprozess ermöglichende Homogenität der Strukturen auf einer Halbleiterscheibe zu gewährleisten. Bei Technologien mit geringeren Homogenitätsanforderungen kann an Stelle der Füllmuster eine homogene Schwärzung oder ein strahlungsdurchlässiger Bereich angeordnet werden.

Die Erfindung betrifft außerdem einen elektronischen Datensatz, dessen Daten die Lage der Muster der erfindungsgemäßen Maskierungsanordnung oder einer ihrer Weiterbildungen festlegen. Der elektronische Datensatz enthält mehrere Datenfelder, die ihrerseits wieder zu Gruppen zusammengefasst sind, beispielsweise eine Gruppe für den ersten Teilbereich, eine Gruppe für den zweiten Teilbereich und eine Gruppe für den Gesamtbereich. Beispielsweise sind die Daten in binärer Form im Datensatz enthalten.

Weiterhin betrifft die Erfindung ein Programm zum Festlegen der Lage von Mustern der erfindungsgemäßen Maskierungsanordnung oder einer ihrer Weiterbildungen. Das Programm enthält insbesondere eine Funktion zum Zusammenfassen des ersten Teilbereiches, der ersten Hilfsmuster und vorzugsweise auch der ersten Testmuster zu einem ersten Block und zum Zusammenfassen des zweiten Teilbereiches, der zweiten Hilfsmuster und vorzugsweise auch der zweiten Testmuster zu einem anderen Block. Bei einer Ausgestaltung ermöglicht das Programm, diese beiden Blöcke gemeinsam mit den dritten Hilfsmustern und den dritten Testmustern zu einem dritten Block zusammenzufassen, der auch als Gesamtblock für die Maskierungsanordnung bezeichnet wird.

Die Erfindung betrifft weiterhin ein Verfahren zum Herstellen von integrierten Schaltungsanordnungen, insbesondere unter Verwendung der erfindungsgemäßen Maskierungsanordnung oder einer ihrer Weiterbildungen. Bei dem erfindungsgemäßen Verfahren werden die folgenden Schritte ausgeführt:

Anfertigen einer Maskierungsanordnung, die mindestens zwei Teilbereiche mit Mustern für jeweils mindestens eine integrierte Nutzschaltungsanordnung enthält, wobei sich die Nutzschaltungsanordnungen dadurch von Testschaltungen unterscheiden, dass die Nutzschaltungsanordnungen später von den Nutzern eines Produkts genutzt werden, wohingegen die Testschaltungen für den Nutzer des Produktes unwesentlich sind, und wobei in den Teilbereichen lithografische Muster für integrierte Schaltungsanordriungen mit voneinander verschiedener Verdrahtung von Bauelementen angeordnet sind,
- Auswählen eines Teilbereiches für die Bestrahlung und Ausnehmen des anderen Teilbereiches von der Bestrahlung, wobei geeignete Maßnahmen beispielsweise ein Zerschneiden der Maskierungsanordnung oder ein Ausblenden nicht benötigter Teilbereiche sind.
- Mindestens einmal oder mehrmals Bestrahlung eines resistbeschichteten Substrats, z.B. einer Fertigungs-Halbleiterscheibe, und Übertragung des Musters des ausgewählten Teilbereiches in die Resistschicht ohne Übertragung des Musters des anderen Teilbereiches in die Resistschicht. Der ausgewählte Teilbereich wird dabei vorzugsweise in die Resistschicht so projiziert, dass die Halbleiterscheibe dicht mit den ausgewählten Teilbereichen bedeckt wird. Die ausgewählten Teilbereiche liegen dann Rand an Rand auf der Halbleiterscheibe.

Durch das erfindungsgemäße Verfahren wird gewährleistet, dass die Herstellungskosten für die Maskierungsanordnung gering sind, weil Muster für mehrere voneinander verschiedene Nutzschaltungsanordnungen auf einer Maskierungsanordnung angeordnet werden können. Zum anderen erhöhen sich die Kosten bei der Produktion einer ausgewählten Schaltungsanordnung aufgrund von Mehrfachbelichtungen nur geringfügig. Nachdem die Maskierungsanordnung aus einer Belichtungsanordnung wieder entfernt worden ist und beispielsweise mehrere Wochen gelagert wurde, wird bei einer Weiterbildung der andere Teilbereich für eine Bestrahlung ausgewählt. Der bereits für die Produktion genutzte Teilbereich und gegebenenfalls auch andere Teilbereiche werden von der Bestrahlung bzw. Belichtung ausgenommen. Anschließend wird mindestens einmal oder mehrmals eine weitere resistbeschichtete Fertigungshalbleiter-Scheibe bestrahlt, wobei das Muster des ausgewählten Teilbereiches in die Resistschicht übertragen wird, ohne dass Muster von anderen Teilbereichen in die Resistschicht übertragen werden. Damit lässt sich auch das andere Produkt mit geringen Fertigungskosten fertigen.

Bei einer nächsten Weiterbildung wird jeweils die Maskierungsanordnung in die Belichtungsanlage eingebracht, in die auch das Fertigungs-Halbleitersubstrat eingebracht wird. Dies bedeutet, dass die Maskierungsanordnung noch Muster für alle Teilbereiche trägt. Nach der Bestrahlung wird die Maskierungsanordnung und das Fertigungs-Halbleitersubstrat aus der Bestrahlvorrichtung entnommen. Die Maskierungsanordnung wird für die nächste Verwendung gelagert. Das Fertigungs-Halbleitersubstrat wird dagegen unabhängig von der Lagerung der Maskierungsanordnung weiter bearbeitet. Gegenüber einem Trennen der Maskierungsanordnung in verschiedene Teilbereiche oder zum Auswählen eines Teilbereiches durch eine andere Maßnahme mit gleicher Wirkung wird so bspw. die Anzahl der zu lagernden Maskierungsanordnungen reduziert.

Bei einer anderen Weiterbildung des erfindungsgemäßen Verfahrens werden insbesondere im Rahmen einer Fertigungsvorbereitung bzw. Musterproduktion die folgenden Schritte ausgeführt:
- Einbringen der Maskierungsanordnung und eines resistbeschichteten Fertigungsvorbereitungs-Halbleitersubstrats in eine Bestrahlvorrichtung,
- sowie Bestrahlen des Fertigungsvorbereitungs-Halbleitersubstrats und Übertragung der Muster beider Teilbereiche in die Resistschicht des Fertigungsvorbereitungs-Halbleitersubstrats.

In der Fertigungsvorbereitungsphase werden auf einem Fertigungsvorbereitungs-Halbleitersubstrat beispielsweise die Schaltungsanordnungen für Produkte A ausgesägt, wobei die Schaltungsanordnungen für Produkte B in anderen Teilbereichen zerstört werden. Auf einem anderen Fertigungsvorbereitungs-Halbleitersubstrat werden dagegen die Produkte B ausgesägt, wobei die Produkte A zerstört werden. Bei den wenigen zur Vorbereitung der Herstellung zu fertigenden Halbleiterscheiben ist ein solches Vorgehen insbesondere im Vergleich zu der Verringerung der Kosten zur Herstellung der Maskierungsanordnung hinnehmbar.

In der Fertigungsphase wird dagegen nur ein Teilbereich der Maskierungsanordnung bestrahlt, so dass benachbarte Bestrahlungsfelder mit in einem Sägeraster ausgerichteten Schaltungsanordnungen auf der Halbleiterscheibe erzeugt werden. Außerdem lässt sich die gesamte Waferfläche dicht mit den ausgewählten Teilbereichen bedecken, obwohl innerhalb des gleichen Maskensatzes bzw. Retikelsatzes Teilbereiche für verschiedene Produkte angeordnet sind.

Die Maskierungsanordnung und das Verfahren sind insbesondere bei kleineren Serien besonders zur Fertigung mit geringem Fertigungsaufwand geeignet, beispielsweise für Produkte, zu deren Herstellung weniger als 1000 Wafer bearbeitet werden.

Es wird für jeden produktiven Teilbereich ein Rahmen vorgesehen, in dem alle optischen Strukturen bzw. elektronischen Strukturen zur Steuerung der Fertigung bzw. zur Qualitätskontrolle der gefertigten Schaltkreise enthalten sind. Außerdem werden gegebenenfalls Füllstrukturen zwischen den Teilbereichen vorgesehen, welche die Herstellung erleichtern oder ermöglichen.

Im Folgenden werden Ausführungsbeispiele der Erfindung an Hand der beiliegenden Zeichnungen erläutert. Darin zeigen:
- Figur 1: eine Draufsicht auf ein Retikel eines Retikelsatzes für die Herstellung zweier Produkte,
- Figur 2: Herstellungsstufen bei der Vorbereitung der Produktion und bei der Produktion von integrierten Schaltkreisen für vier verschiedene Produkte, und
- Figur 3: Draufsicht auf eine Halbleiterscheibe zur Herstellung eines der vier Produkte.

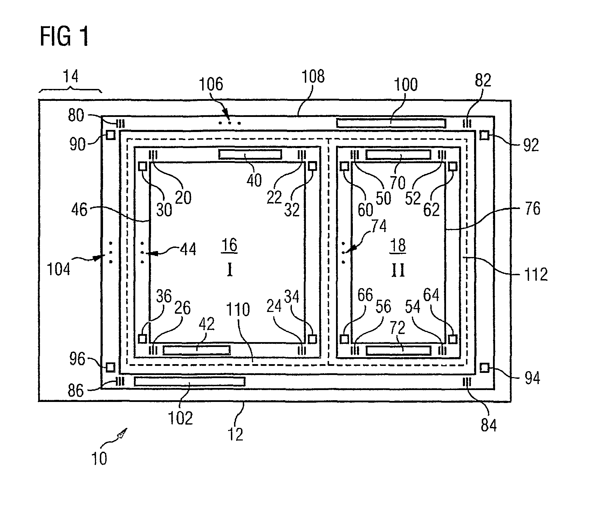

Figur 1 zeigt eine Draufsicht auf ein Retikel 10 eines Retikelsatzes für die Herstellung zweier Produkte I und II. Der Retikelsatz enthält außer dem Retikel 10 beispielsweise noch 30 oder mehr als 30 andere Retikel. Jedes Retikel des Retikelsatzes ist wie das Retikel 10 auf einem Retikelsubstrat 12 angeordnet, beispielsweise auf einem Glassubstrat. Ein linker Randbereich 14 jedes Retikels dient der Handhabung und enthält keine Muster. Jedes Retikel des Retikelsatzes enthält wie das Retikel 10 zwei Teilbereiche 16, 18, in denen Muster zur Herstellung der Nutz-Schaltungsanordnungen angeordnet sind. Der Teilbereich 16 liegt in einem mittleren Teil des Retikels 10 und hat eine fast quadratische Form. Im Teilbereich 16 sind Muster zur Herstellung des Produktes I angeordnet. Der Teilbereich 18 liegt im rechten Teil des Retikels 10 und hat eine rechteckige Form. Im Teilbereich 18 liegen Muster zur Herstellung des Produktes II.

Der Teilbereich 16 wird von vier Ausrichtmarken 20 bis 26, von vier Überlappungsmarken 30 bis 36, von zwei Teststrukturen 40, 42 sowie von weiteren Hilfsmustern 44 umgeben, die alle zusammen einen fast quadratischen Rahmen 46 bilden, der den Teilbereich 16 vollständig umgibt. Die Ausrichtmarken 20 bis 26 und die Überlappungsmarken 30 bis 36 befinden sich jeweils an den Ecken des Teilbereiches 16. Die Ausrichtmarken 20 bis 26 enthalten beispielsweise jeweils drei oder fünf parallel zueinander angeordnete Balken, die in vertikaler Richtung verlaufen. Die Überlappungsmarken 30 bis 36 enthalten jeweils einen quadratischen Rahmen. Die Abmessungen der Ausrichtmarken 20 bis 26 und der Überlappungsmarken 30 bis 36 sind jeweils beispielsweise kleiner als 20 µm. Die Teststruktur 40 liegt zwischen den Ausrichtmarken 20 und 22 im rechten Teil des oberen Rahmensteges des Rahmens 46. Die Teststruktur 42 liegen zwischen den Ausrichtmarken 24 und 26 im linken Teil des unteren Rahmensteges des Rahmens 46.

Der Teilbereich 18 wird von Ausrichtmarken 50 bis 56, von Überlappungsmarken 60 bis 66, von Teststrukturen 70, 72 und von weiteren Hilfsstrukturen 74 umgeben, die alle gemeinsam einen rechteckförmigen Rahmen 76 bilden. Die Ausrichtmarken 50 bis 56 und die Überlappungsmarken 60 bis 66 sind jeweils in den Ecken des Rahmens 76 angeordnet. Die Ausrichtmarken 50 bis 56 enthalten jeweils drei oder bei einem anderen Ausführungsbeispiel fünf vertikale Balken. Die Überlappungsmarken 60 bis 66 sind jeweils rechteckförmige Rahmen. Die Teststruktur 70 liegt zwischen den Ausrichtmarken 50 und 52. Die Teststruktur 72 liegt zwischen den Ausrichtmarken 54 und 56 am unteren Rahmensteg des Rahmens 76. Die Größen der Strukturen des Rahmens 76 sind gleich der Größe der Strukturen des Rahmens 46.

Die beiden Rahmen 46 und 76 werden von vier Ausrichtmarken 80 bis 86, von vier Überlappungsmarken 90 bis 96, von zwei Teststrukturen 100, 102 sowie von weiteren Hilfsstrukturen 104, 106 umgeben, die alle gemeinsam einen Überrahmen 108 bilden. Die Ausrichtmarken 80 bis 86 und die Überlappungsmarken 90 bis 96 sind in den Ecken des Überrahmens 108 angeordnet und haben den gleichen Aufbau wie die Ausrichtmarken 20 bis 26 bzw. 50 bis 56 und wie die Überlappungsmarken 30 bis 36 bzw. 60 bis 66. Die Teststrubaur 100 ist zwischen den Ausrichtmarken 80 und 82 im oberen Rahmensteg des Überrahmens 108 angeordnet. Die Teststruktur 102 ist zwischen den Ausrichtmarken 84 und 86 im unteren Rahmensteg des Überrahmens 108 angeordnet.

Damit ist die Anordnung der Ausrichtmarken 20 bis 26, 50 bis 56, 80 bis 86 und der Überlappungsmarken 30 bis 36, 60 bis 66 und 90 bis 96 in dem jeweiligen Rahmen 46, 76 bzw. 108 ähnlich im Vergleich zu den jeweils anderen Rahmen. In anderen Retikeln des Retikelsatzes befinden sich Ausrichtmarken und Überlappungsmarken auch in der Nähe der Ecken der jeweiligen Rahmen, jedoch gegebenenfalls mit einem Versatz zu den an Hand der Figur 1 erläuterten Überlappungsmarken.

Das Retikel 10 enthält in den Rahmen 46, 76 und im Überrahmen 108 auch noch andere Marken, beispielsweise Marken für die horizontale Ausrichtung, die wie die Ausrichtmarken 20 bis 26 aufgebaut sind, deren Balken jedoch in horizontaler Richtung liegen.

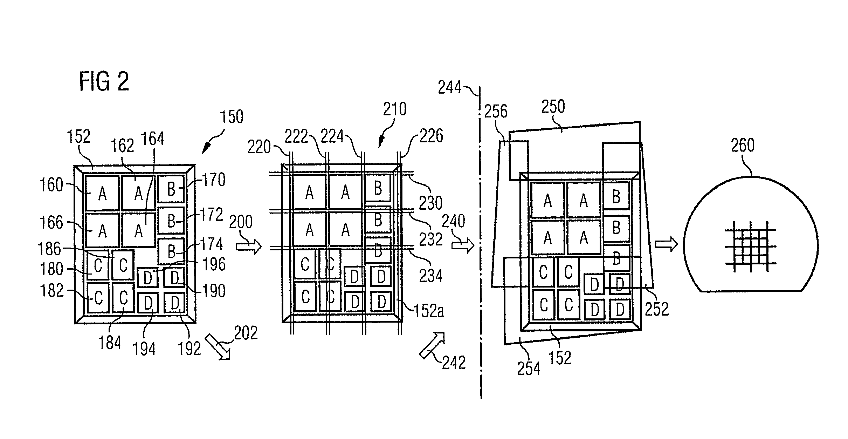

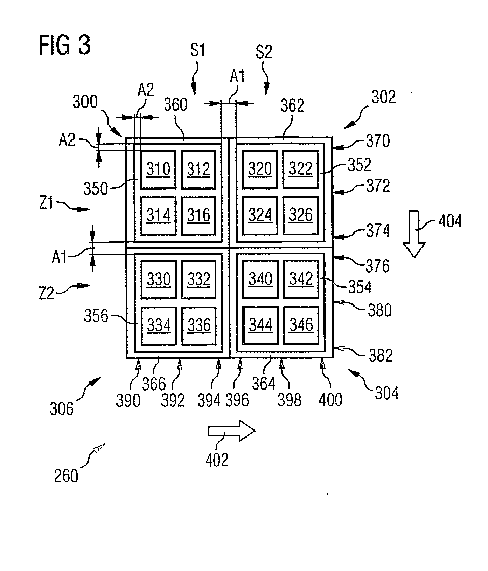

Wie unten an Hand der Figuren 2 und 3 für ein Retikel eines anderen Retikelsatzes erläutert, lassen sich mit dem Retikelsatz, zu dem auch das Retikel 10 gehört, drei verschiedene Herstellungsverfahren durchführen, nämlich:
- Herstellung beider Produkte I und II unter Verwendung des Überrahmens 108 und ohne Abdeckung von Teilbereichen 16 bzw. 18,
- Herstellung nur des Produktes I unter Verwendung des Rahmens 46 und unter gleichzeitiger Abdeckung des Teilbereiches 18, des Rahmens 76 und des Überrahmens 108, und
- alleinige Produktion des Produktes II unter Verwendung des Rahmens 76 und unter gleichzeitiger Abdeckung des Teilbereiches 16, des Rahmens 46 und des Rahmens 106.

Der Bereich zwischen dem Rahmen 46, 76 und 108 ist beispielsweise geschwärzt. Jedoch gibt es auch Ausführungsbeispiele ohne Schwärzung.

So trägt das Retikel bei einem anderen Ausführungsbeispiel trägt 10 außerdem Füllstrukturen, die in zwei Füllrahmen 110, 112 angeordnet sind. Der Füllrahmen 110 grenzt an den Rahmen 46. Der Füllrahmen 112 grenzt an den Rahmen 76. Beide Füllrahmen 110 und 112 liegen innerhalb des Überrahmens 108. Die Funktion der Füllrahmen 110 und 112 wird unten an Hand der Figuren 2 und 3 ebenfalls näher erläutert.

Bei einem anderen Ausführungsbeispiel befindet sich zwischen benachbarten Seiten der Füllrahmen 110 und 112 ein Abstand. Der Abstand ist beispielsweise größer als 10 Mikrometer oder größer als 100 Mikrometer.

Figur 2 zeigt Herstellungsstufen zur Vorbereitung der Produktion und zur Produktion von integrierten Schaltkreisen für vier verschiedene Produkte A bis D. Bei einem Retikelhersteller wird die Herstellung eines Retikelsatzes in Auftrag gegeben, der ein Retikel 150 enthält. Das Retikel 150 enthält umgeben von einem dem Überrahmen 108 ähnlichen Überrahmen 152:
- in seiner oberen linken Ecke vier Subbereiche 160 bis 166 für vier Produkte A. Die Teilbereiche 160 bis 166 sind in zwei Zeilen und zwei Spalten so angeordnet, dass ein quadratischer Teilbereich für das Produkt A gebildet wird.
- im oberen und mittleren Teil des rechten Randbereiches für drei Produkte B drei quadratische Subbereiche 170 bis 174, die in einer Spalte angeordnet sind.
- in der linken unteren Ecke für vier Produkte C vier Subbereiche 180 bis 186, die ebenfalls in zwei Zeilen und zwei Spalten angeordnet sind, und
- in der rechten unteren Ecke für vier Produkte D vier Subbereiche 190 bis 196, die ebenfalls in zwei Zeilen und zwei Spalten angeordnet sind.

Die Subbereiche 160 bis 166, 170 bis 174, 180 bis 186 bzw. 190 bis 196 für ein Produkt A, B ,C bzw. D bilden jeweils einen Teilbereich, der von einem eigenen Rahmen umgeben ist, der Ausrichtmarken, Überlappungsmarken und Teststrukturen enthält. Auch der Überrahmen 152 enthält Ausrichtmarken, Überlappungsmarken und Teststrukturen. Einzelne Subbereiche 160 bis 196 sind dagegen nicht von einem nur sie umgebenden Rahmen mit Hilfsstrukturen umgeben.

Ausgehend von dem Retikelsatz des Retikels 150 werden vier Testwafer hergestellt, siehe Pfeile 200 und 202. Im Fall des Pfeils 200 wird ein Testwafer 210 für Testschaltungen des Produktes A hergestellt. In einem auf dem Testwafer 210 hergestellten Überrahmen 152a sind Ausrichtmuster, Überlappungsmuster und Teststrukturen angeordnet, die mit Hilfe der im Überrahmen 152 angeordneten Ausrichtmuster, Überlappungsmuster und Teststrukturen erzeugt worden sind. Vertikale Sägelinien 220 bis 226 und horizontale Sägelinien 230, 232 und 234 dienen zum Ausschneiden von Chips für das Produkt A. Beim Sägen werden ein Großteil der anderen Chips für die Produkte B, C und D zersägt, da sie nicht zwingend im Raster der Sägelinien 220 bis 234 liegen.

Wie durch Pfeile 240 und 242 angedeutet, werden anschließend Tests zur Überprüfung des Designs für die Testschaltungen der Produkte A bis D durchgeführt. Im Ausführungsbeispiel wird davon ausgegangen, dass diese Tests fehlerfrei verlaufen. Eine vertikale gestrichelte Linie 244 verdeutlicht den Abschluss der Produktionsvorbereitung zw. Fertigungsvorbereitung. Der Retikelsatz, zu dem auch das Retikel 150 gehört, wird in einer Retikelbibliothek aufbewahrt, bis beispielsweise das Produkt A nach dem Eingang der Bestellung eines Kunden hergestellt werden soll.

Während bei der Herstellung des Testwafers 210 keine Subbereiche 160 bis 196 ausgeblendet worden sind, wird zur Herstellung des Produktes A eine Belichtungsvorrichtung mit vier Blenden 250 bis 256 verwendet, mit deren Hilfe nur die Subbereiche 160 bis 166, d.h. der Teilbereich für das Produkt A, sowie der nur diesen Teilbereich umgebende Rahmen und ggf. der zugehörige Füllrahmen auf einen Produktionswafer 260 übertragen werden. Die Blende 250 deckt den oberen Rahmensteg des Überrahmens 152 ab. Die rechte Blende 252 deckt die Subbereiche 170 bis 174 für das Produkt B ab. Die untere Blende 254 deckt die Subbereiche 190 bis 196 für das Produkt C und für das Produkt D ab. Die linke Blende 256 deckt den linken Rahmensteg des Überrahmens 152 ab. Die auf dem Produktionswafer 260 erzeugten Belichtungsstrukturen werden im Folgenden an Hand der Figur 3 näher erläutert.

Figur 3 zeigt eine Draufsicht auf einen Ausschnitt des Produktionswafers 260 nach dem Ende des mit dem Retikel 150 durchgeführten Lithografieverfahrens. Vier jeweils mit einer Teilbelichtung erzeugte Teilbereiche 300 bis 306 sind in zwei Spalten S1, S2 und zwei Zeilen Z1, Z2 matrixförmig angeordnet, wobei jeder Bereich 300 bis 306 seinerseits jeweils vier Subbereiche 310 bis 316, 320 bis 326, 330 bis 336 bzw. 340 bis 346 enthält. Beispielsweise wurden die vier Subbereiche 310 bis 316 mit Hilfe der Subbereiche 160 , 162, 166 und 164 erzeugt, insbesondere der Subbereich 310 mit dem Subbereich 160 und der Subbereich 312 mit dem Subbereich 162.

Die Teilbereiche 300 bis 306 sind jeweils von einem Rahmen 350 bis 356 umgeben. Die Rahmen 350 bis 356 enthalten jeweils in den Ecken Ausrichtmarken und Überlappmarken. In den Randbereichen der Rahmen 350 bis 356 sind Teststrukturen angeordnet. Zwischen den Subbereichen eines Teilbereiches 300 bis 306, z.B. zwischen den Subbereichen 310, 312, 314 und 316 befinden sich vertikale bzw. horizontale Streifen, in denen später Sägelinien verlaufen. Innerhalb dieser Streifen sind bei einem Ausführungsbeispiel ebenfalls Ausrichtmarken, Überlappmarken und Teststrukturen angeordnet.

Außerdem ist jeder Rahmen 350 bis 356 von Füllrahmen 360 bis 366 umgeben, in denen sich ausgesparte und hervorstehende rechteckförmige Bereiche abwechseln. Die Füllrahmen benachbarter Teilbereiche 300 bis 306 grenzen aneinander an. Ein Abstand A1 gibt die zweifache Breite des mit Füllstrukturen belichteten Bereiches eines Füllrahmens an. Im Ausführungsbeispiel beträgt der Abstand A1 900 µm (Mikrometer). Bei anderen Ausführungsbeispielen liegt die Größe des Abstandes A1 bspw. zwischen 100 µm und 1 mm (Millimeter). Die Stege der Rahmen 350 bis 356 sind jeweils bspw. 90 µm breit, siehe Abstand A2. Die Lage von horizontalen Sägelinien 370 bis 382 und von vertikalen Sägelinien 390 bis 400 ist in Figur 3 durch Pfeile dargestellt. Da alle Schaltungsanordnungen auf dem Produktionswafer 260 im Raster von Säglinien liegen, wird ohne Zerstörung von Schaltungsanordnungen getrennt.

Die in Figur 3 gezeigte Struktur setzt sich in einer durch einen Pfeil angedeuteten Zeilenrichtung 402 und in einer durch einen Pfeil angedeuteten Spaltenrichtung 404 fort. Überrahmen, die dem Überrahmen 152 entsprechen, sind auf dem Produktionswafer 260 nicht angeordnet.

Bei anderen Ausführungsbeispielen liegen mehr als vier Teilbereiche innerhalb eines Belichtungsbereiches für die Herstellung eines Produktes. Außerdem werden bei anderen Ausführungsbeispielen keine Füllrahmen 360 bis 366 verwendet.

Bei einem anderen Ausführungsbeispiel ist der Überrahmen 108 nicht vorhanden. Statt dessen werden bei der gleichzeitigen Herstellung beider Produkte I und II die Ausrichtmarken und die Teststrukturen beider Rahmen 46 und 76 verwendet. Zur Ausrichtung werden nur die Ausrichtmarken 20, 52, 54 und 26 verwendet, d.h. die in den Ecken eines Gesamtbereiches aus den beiden Teilbereichen angeordneten Ausrichtmarken. Die Ausrichtmarken 22, 50, 56 und 24 werden dagegen bei der gleichzeitigen Herstellung nicht für die Ausrichtung genutzt.

Bei einem weiteren Ausführungsbeispiel werden Füllmuster auf dem Retikel nur an zwei aneinandergrenzenden Seiten jedes Teilbereiches angeordnet und nicht an den anderen beiden Seiten. Durch Belichtung benachbarter Teilbereiche entsteht auf dem wafer aber ein Füllstrukturrahmen. Der Abstand A1 entspricht bei diesem Ausführungsbeispiel nur noch der einfachen Breite eines Füllmustersteges. Insbesondere sind Füllstrukturen am Masken- bzw. Retikelrand nicht erforderlich, da dort bspw. durch ein Fassung des Retikels abgeblendet wird, die sich gemeinsam mit dem Retikel im Fokus der Belichtungsanlage befindet. Nur zusätzlich erforderliche Blenden befinden sich außerhalb der fokussierten Ebene und werden unscharf abgebildet. Dies ist jedoch auf Grund der Füllmuster oder eines geeigneten Abstandes hinnehmbar.

Bei beiden Fällen der Anordnung von Füllmustern können mit verschiednen Belichtungen erzeugte Füllstrukturen auf dem Wafer sowohl überlappend als auch nicht überlappend angeordnet werden.

## Patentansprüche

1. Maskierungsanordnung (10) zur Herstellung von integrierten Schaltungsanordnungen,
mit einem Trägersubstrat (12),
mit vom Trägersubstrat (12) getragenen lithografischen Mustern, die in mindestens zwei Teilbereichen (16, 18) angeordnet sind, von denen jeder Teilbereich (16, 18) Muster für jeweils mindestens eine integrierte Schaltungsanordnung (A, B) enthält,
wobei in den Teilbereichen (16, 18) lithografische Muster für integrierte Schaltungsanordnungen (A, B) mit voneinander verschiedener Verdrahtung von Bauelementen angeordnet sind,
mit ersten Hilfsmustern (20) für die Ausrichtung mehrerer Lithografieebenen bei der Herstellung der einen Schaltungsanordnung (A) ohne gleichzeitige Herstellung der anderen Schaltungsanordnung (B),
und mit zweiten Hilfsmustern (50) für die Ausrichtung mehrerer Lithografieebenen bei der Herstellung der anderen Schaltungsanordnung (B) ohne gleichzeitige Herstellung der einen Schaltungsanordnung (A).

2. Maskierungsanordnung (10) nach Anspruch 1, **gekennzeichnet durch** dritte Hilfsmuster (80) für die Ausrichtung mehrerer Lithografieebenen bei der gleichzeitigen Herstellung beider Schaltungsanordnungen (A, B),
wobei die dritten Hilfsmuster (80) eine Kombination aus ersten Hilfsmustern (20) und zweiten Hilfsmustern (50) enthalten oder wobei die dritten Hilfsmuster (80) zusätzlich zu den ersten Hilfsmustern (20) und zu den zweiten Hilfsmustern (50) vorhanden sind.

3. Maskierungsanordnung (10) nach Anspruch 1 oder 2, **dadurch gekennzeichnet, dass** die ersten Hilfsmuster (20) an dem einen Teilbereich (16) und vorzugsweise auch in dem einen Teilbereich (16) angeordnet sind,
dass die zweiten Hilfsmuster (50) an dem anderen Teilbereich (18) und vorzugsweise auch in dem anderen Teilbereich (18) angeordnet sind,
und dass die dritten Hilfsmuster (80) an einem von den Teilbereichen gebildeten Gesamtbereich (16, 18) und vorzugsweise auch im Gesamtbereich (16, 18) angeordnet sind,
und/oder dass zwischen den Teilbereichen (16, 18) erste Hilfsmuster (32) an anderen Orten als zweite Hilfsmuster (60) angeordnet sind,
und/oder dass die dritten Hilfsmuster (80) an anderen Orten, vorzugsweise näher am Rand der Maskierungsanordnung (10), angeordnet sind, als die ersten Hilfsmuster (20) und die zweiten Hilfsmuster (50).

4. Maskierungsanordnung (10) nach einem der vorhergehenden Ansprüche, **dadurch gekennzeichnet, dass** erste Hilfsmuster (20) nahe von Ecken des einen Teilbereiches (16) angeordnet sind, vorzugsweise mindestens ein erstes Hilfsmuster (20) nahe jeder Ecke des einen Teilbereiches (16),
und/oder dass zweite Hilfsmuster (50) nahe von Ecken des anderen Teilbereiches (18) angeordnet sind, vorzugsweise mindestens ein zweites Hilfsmuster (50) nahe jeder Ecke des anderen Teilbereiches (18),
und/oder dass dritte Hilfsmuster (80) nahe von Ecken eines von den Teilbereichen (16, 18) gebildeten Gesamtbereiches angeordnet sind, vorzugsweise mindestens ein drittes Hilfsmuster (80) nahe jeder Ecke des Gesamtbereiches.

5. Maskierungsanordnung (10) nach einem der vorhergehenden Ansprüche, **dadurch gekennzeichnet, dass** ein Hilfsmuster (20) mindestens eine Ausrichtmarke (20) enthält, die das Ausrichten der Maskierungsanordnung (10) und einer integrierten Schaltungsanordnung ermöglicht, vorzugsweise eine Ausrichtmarke (20), die mindestens ein Kreuz enthält oder vorzugsweise eine Ausrichtmarke (20), die mehrere zueinander parallel angeordnete geradlinige Strukturen enthält,
und/oder dass ein Hilfsmuster (30) mindestens eine Überlappungsmarke (30) enthält, die eine Überprüfung des Versatzes einer mit Hilfe der Maskierungsanordnung (10) ausgeführten Bestrahlung ermöglicht, vorzugsweise eine Überlappungsmarke (30), die mindestens einen Rahmen oder mindestens eine rechteckförmige oder quadratische Fläche enthält.

6. Maskierungsanordnung (10) nach einem der vorhergehenden Ansprüche, **gekennzeichnet durch** mindestens ein erstes Testmuster (40) für die Herstellung einer Testschaltungsanordnung gleichzeitig mit der einen Schaltungsanordnung (A),
und **durch** mindestens ein zweites Testmuster (70) für die Herstellung einer Testschaltungsanordnung gleichzeitig mit der anderen Schaltungsanordnung (B),
und/oder **durch** mindestens ein drittes Testmuster (100) für die Herstellung einer Testschaltungsanordnung gleichzeitig mit den beiden Schaltungsanordnungen (A, B).

7. Maskierungsanordnung (10) nach Anspruch 6, **dadurch gekennzeichnet, dass** erste Hilfsmuster (20, 30) und erste Testmuster (40) um den einen Teilbereich (16) herum einen Rahmen (46) bilden,
und dass zweite Hilfsmuster (50) und zweite Testmuster (70) um den anderen Teilbereich (18) herum einen anderen Rahmen (76) bilden,
und/oder dass dritte Hilfsmuster (80) und dritte Testmuster (100) um die beiden Rahmen (46, 76) herum einen weiteren Rahmen (108) bilden.

8. Maskierungsanordnung (10) nach einem der vorhergehenden Ansprüche, **dadurch gekennzeichnet, dass** die Maskierungsanordnung (10) eine Maske für eine 1:1-Bestrahlung ist, insbesondere in einem Waferstepper oder einem Waferscanner,
oder dass die Maskierungsanordnung (10) ein Retikel für eine Bestrahlung mit Verkleinerung der lithografischen Muster ist, insbesondere in einem Waferstepper oder einem Waferscanner.

9. Maskierungsanordnung (10) nach einem der vorhergehenden Ansprüche, **dadurch gekennzeichnet, dass** in einem Teilbereich (16, 18) lithografische Muster für mehrere Schaltungsanordnungen (A) mit untereinander gleicher Verdrahtung von Bauelementen angeordnet sind.

10. Maskierungsanordnung (10) nach einem der vorhergehenden Ansprüche, **gekennzeichnet durch** Füllmuster zwischen dem ersten Teilbereich (16) und dem zweiten Teilbereich (18),
wobei vorzugsweise ein erster Füllmusterrahmen (110) den ersten Teilbereich (16) und vorzugsweise die ersten Hilfsmuster (20) und vorzugsweise die ersten Testmuster umgibt,
und wobei vorzugsweise ein zweiter Füllmusterrahmen (112) den zweiten Teilbereich (18) und vorzugsweise die zweiten Hilfsmuster (50) und vorzugsweise die zweiten Testmuster umgibt.

11. Elektronischer Speicher, enthaltend einen Datensatz, dessen Daten die Lage der Muster einer Maskierungsanordnung (10) nach einem der vorhergehenden Ansprüche festlegen.

12. Computerprogramm, dass wenn auf einem Rechner ausgeführt, die Lage von Mustern einer Maskierungsanordnung (10) nach einem der Ansprüche 1 bis 10 festlegt, insbesondere mit einer Funktion zum Zusammenfassen eines ersten Teilbereiches (16) und zum ersten Teilbereich (16) gehörenden Hilfsmustern (20) zu einem ersten Block und zum Zusammenfassen eines zweiten Teilbereiches (18) und zum zweiten Teilbereich (18) gehörenden Hilfsmustern (50) zu einem anderen Block.

13. Verfahren zur Herstellung von integrierten Schaltungsanordnungen (A, B), insbesondere unter Verwendung einer Maskierungsanordnung (150) nach einem der Ansprüche 1 bis 10,
mit den ohne Beschränkung durch die angegebene Reihenfolge auszuführenden Schritten:
Anfertigen einer Maskierungsanordnung (150), die mindestens zwei Teilbereiche (160, 170) mit Mustern für jeweils mindestens eine integrierte Nutzschaltungsanordnung (A, B) enthält, wobei sich die Nutzschaltungsanordnungen **dadurch** von Testschaltungen unterscheiden, dass die Nutzschaltungsanordnungen später von den Nutzern eines Produkts genutzt werden, wohingegen die Testschaltungen für den Nutzer des Produktes unwesentlich sind,
und wobei in den Teilbereichen (16, 18) lithografische Muster für integrierte Schaltungsanordnungen (A, B) mit voneinander verschiedener Verdrahtung von Bauelementen angeordnet sind, Auswählen eines Teilbereiches (160) für eine Bestrahlung und Ausnehmen des anderen Teilbereiches (170) von der Bestrahlung,
mindestens einmal oder mehrmals Bestrahlung eines resistbeschichteten Fertigungs-Substrats (260) und Übertragung des Musters des ausgewählten Teilbereiches (160) in die Resistschicht ohne Übertragung des Musters des anderen Teilbereiches (170) in die Resistschicht.

14. Verfahren nach Anspruch 13, **gekennzeichnet durch** die Schritte:
Auswählen des anderen Teilbereiches (170) für eine Bestrahlung und Ausnehmen des einen Teilbereiches (160) von der Bestrahlung,
mindestens einmal oder mehrmals Bestrahlung eines weiteren resistbeschichteten Fertigungs-Substrats und Übertragung des Musters des ausgewählten Teilbereiches (170) in die Resistschicht ohne Übertragung des Musters des einen Teilbereiches (160) in die Resistschicht.

15. Verfahren nach Anspruch 13 oder 14, **gekennzeichnet durch** die Schritte:
Einbringen der Maskierungsanordnung (150) in eine Bestrahlvorrichtung und Einbringen des einen Fertigungs-Substrats (260) in die Bestrahlvorrichtung vor der Bestrahlung,
und vorzugsweise Entnehmen der Maskierungsanordnung (150) aus der Bestrahlvorrichtung, insbesondere vor einem erneuten Einbringen der Maskierungsanordnung (150) und insbesondere vor dem Einbringen des weiteren Fertigungs-Substrats.

16. Verfahren nach einem der Ansprüche 12 bis 15, **gekennzeichnet durch** die insbesondere vor dem Einbringen und/oder dem Bestrahlen des Fertigungs-Substrats (260) ausgeführten Schritte:
Einbringen der Maskierungsanordnung (10) und eines resistbeschichteten Fertigungsvorbereitungs-Substrats (210) in eine Bestrahlvorrichtung,
Bestrahlen des Fertigungsvorbereitungs-Substrats (210) und Übertragung der Muster beider Teilbereiche (16, 18) in die Resistschicht des Fertigungsvorbereitungs-Substrats (210).

## Claims

1. Masking arrangement (10) for producing integrated circuit arrangements
having a carrier substrate (12),
having lithographic patterns which are carried by the carrier substrate (12) and are arranged in at least two partial regions (16, 18), of which each partial region (16, 18) contains patterns for at least one respective integrated circuit arrangement (A, B),
lithographic patterns for integrated circuit arrangements (A, B) with mutually different wiring of components being arranged in the partial regions (16, 18),
having first auxiliary patterns (20) for the alignment of a plurality of lithography planes during the production of one circuit arrangement (A) without simultaneous production of the other circuit arrangement (B),
and having second auxiliary patterns (50) for the alignment of a plurality of lithography planes during the production of the other circuit arrangement (B) without simultaneous production of said one circuit arrangement (A).

2. Masking arrangement (10) according to Claim 1, **characterized by** third auxiliary patterns (80) for the alignment of a plurality of lithography planes during the simultaneous production of both circuit arrangements (A, B),
the third auxiliary patterns (80) containing a combination of first auxiliary patterns (20) and second auxiliary patterns (50),
or the third auxiliary patterns (80) being present in addition to the first auxiliary patterns (20) and the second auxiliary patterns (50).

3. Masking arrangement (10) according to Claim 1 or 2, **characterized in that** the first auxiliary patterns (20) are arranged at one partial region (16) and preferably also in one partial region (16),
**in that** the second auxiliary patterns (50) are arranged at the other partial region (18) and preferably also in the other partial region (18),
and **in that** the third auxiliary patterns (80) are arranged at an overall region (16, 18) formed by the partial regions and preferably also in the overall region (16, 18),
and/or **in that**, between the partial regions (16, 18), first auxiliary patterns (32) are arranged at different locations than second auxiliary patterns (60),
and/or **in that** the third auxiliary patterns (80) are arranged at different locations, preferably closer to the edge of the masking arrangement (10), than the first auxiliary patterns (20) and the second auxiliary patterns (50) .

4. Masking arrangement (10) according to one of the preceding claims, **characterized in that** first auxiliary patterns (20) are arranged close to corners of one partial region (16), preferably at least one first auxiliary pattern (20) close to each corner of said one partial region (16),
and/or **in that** second auxiliary patterns (50) are arranged close to corners of the other partial region (18), preferably at least one second auxiliary pattern (50) close to each corner of the other partial region (18),
and/or **in that** third auxiliary patterns (80) are arranged close to corners of an overall region formed by the partial regions (16, 18), preferably at least one third auxiliary pattern (80) close to each corner of the overall region.

5. Masking arrangement (10) according to one of the preceding claims, **characterized in that** an auxiliary pattern (20) contains at least one alignment mark (20) which enables the alignment of the masking arrangement (10) and of an integrated circuit arrangement, preferably an alignment mark (20) which contains at least one cross or preferably an alignment mark (20) which contains a plurality of rectilinear structures arranged parallel to one another,
and/or **in that** an auxiliary pattern (30) contains at least one overlap mark (30) which enables a checking of the offset of an irradiation performed with the aid of the masking arrangement (10), preferably an overlap mark (30) which contains at least one frame or at least one rectangular or square area.

6. Masking arrangement (10) according to one of the preceding claims, **characterized by** at least one first test pattern (40) for the production of a test circuit arrangement at the same time as one circuit arrangement (A),
and by at least one second test pattern (70) for the production of a test circuit arrangement at the same time as the other circuit arrangement (B),
and/or by at least one third test pattern (100) for the production of a test circuit arrangement at the same time as both the circuit arrangements (A, B).

7. Masking arrangement (10) according to Claim 6, **characterized in that** first auxiliary patterns (20, 30) and first test patterns (40) form one frame (46) around one partial region (16),
and **in that** second auxiliary patterns (50) and second test patterns (70) form another frame (76) around the other partial region (18),
and/or **in that** third auxiliary patterns (80) and third test patterns (100) form a further frame (108) around the two frames (46, 76).

8. Masking arrangement (10) according to one of the preceding claims, **characterized in that** the masking arrangement (10) is a mask for a 1:1 irradiation, in particular in a wafer stepper or a wafer scanner,
or **in that** the masking arrangement (10) is a reticle for an irradiation with demagnification of the lithographic patterns, in particular in a wafer stepper or a wafer scanner.

9. Masking arrangement (10) according to one of the preceding claims, **characterized in that** lithographic patterns for a plurality of circuit arrangements (A) with mutually identical wiring of components are arranged in a partial region (16, 18).

10. Masking arrangement (10) according to one of the preceding claims, **characterized by** filling patterns between the first partial region (16) and the second partial region (18),
preferably a first filling pattern frame (110) surrounding the first partial region (16) and preferably the first auxiliary patterns (20) and preferably the first test patterns,
and preferably a second filling pattern frame (112) surrounding the second partial region (18) and preferably the second auxiliary patterns (50) and preferably the second test patterns.

11. Electronic memory containing a data record, the data of which define the position of the patterns of a masking arrangement (10) according to one of the preceding claims.

12. Computer program which, when executed on a computer, defines the position of patterns of a masking arrangement (10) according to one of Claims 1 to 10, in particular with a function for combining a first partial region (16) and auxiliary patterns (20) associated with the first partial region (16) to form a first block and for combining a second partial region (18) and auxiliary patterns (50) associated with the second partial region (18) to form another block.

13. Method for producing integrated circuit arrangements (A, B), in particular using a masking arrangement (150) according to one of Claims 1 to 10, having the following steps to be performed without restriction by the order specified:
fabrication of a masking arrangement (150) containing at least two partial regions (160, 170) with patterns for in each case at least one integrated useful circuit arrangement (A, B),
the useful circuit arrangements differing from test circuits by virtue of the fact that the useful circuit arrangements are later utilized by the users of a product, whereas the test circuits are unimportant to the user of the product,
and lithographic patterns for integrated circuit arrangements (A, B) with mutually different wiring of components being arranged in the partial regions (16, 18),
selection of one partial region (160) for an irradiation and exclusion of the other partial region (170) from the irradiation,
at least once or repeatedly, irradiation of a resist-coated fabrication substrate (260) and transfer of the pattern of the selected partial region (160) into the resist layer without transfer of the pattern of the other partial region (170) into the resist layer.

14. Method according to Claim 13, **characterized by** the following steps:
selection of the other partial region (170) for an irradiation and exclusion of said one partial region (160) from the irradiation,
at least once or repeatedly, irradiation of a further resist-coated fabrication substrate and transfer of the pattern of the selected partial region (170) into the resist layer without transfer of the pattern of said one partial region (160) into the resist layer.

15. Method according to Claim 13 or 14, **characterized by** the following steps:
introduction of the masking arrangement (150) into an irradiation device and introduction of one fabrication substrate (260) into the irradiation device prior to the irradiation,
and preferably removal of the masking arrangement (150) from the irradiation device, in particular prior to a renewed introduction of the masking arrangement (150) and in particular prior to the introduction of the further fabrication substrate.

16. Method according to one of Claims 12 to 15, **characterized by** the following steps performed in particular prior to the introduction and/or the irradiation of the fabrication substrate (260):
introduction of the masking arrangement (10) and of a resist-coated fabrication preparation substrate (210) into an irradiation device,
irradiation of the fabrication preparation substrate (210) and transfer of the patterns of both partial regions (16, 18) into the resist layer of the fabrication preparation substrate (210).

## Revendications

1. Système (10) de réserve pour la production de configurations de circuits intégrés,
comprenant un substrat (12) servant de support,
comprenant des motifs lithographiques portés par le substrat (12) servant de support qui sont disposés dans au moins deux sous-zones (16, 18) dont chacune (16, 18) comporte des motifs pour, respectivement, au moins une configuration (A, B) de circuit intégré, des motifs lithographiques dans les sous-zones (16, 18) pour des configurations (A, B) de circuits intégrés étant disposés en ayant des câblages différents les uns des autres de composants,
comprenant des premiers motifs (20) auxiliaires pour l'alignement de plusieurs plans de lithographie lors de la production de l'une des configurations (A) de circuits sans production simultanée de l'autre configuration (B) de circuit,
et comprenant des deuxièmes motifs (50) auxiliaires pour l'alignement de plusieurs plans de lithographie lors de la production de l'autre configuration (B) de circuit sans production simultanée de l'une des configurations (A) de circuits.

2. Système (10) de réserve suivant la revendication 1, **caractérisé par** des troisièmes motifs (80) auxiliaires pour l'alignement de plusieurs plans de lithographie lors de la production simultanée des deux configurations (A, B) de circuits,
dans lequel les troisièmes motifs (80) auxiliaires comportent une combinaison de premiers motifs (20) auxiliaires et de deuxièmes motifs (50) auxiliaires ou dans lequel les troisièmes motifs (80) auxiliaires sont présents en plus des premiers motifs (20) auxiliaires et des deuxièmes motifs (50) auxiliaires.

3. Système (10) de réserve suivant la revendication 1 ou 2, **caractérisé en ce que** les premiers motifs (20) auxiliaires sont disposés sur l'une des sous-zones (16) et de préférence aussi dans l'une des sous-zones (16),
**en ce que** les deuxièmes motifs (50) auxiliaires sont disposés sur l'autre sous-zone (18) et de préférence aussi dans l'autre sous-zone (18),
et **en ce que** les troisièmes motifs (80) auxiliaires sont disposés sur l'une des zones (16, 18) totales formées par les sous-zones et de préférence aussi dans la zone (16, 18) totale,
et/ou **en ce qu'**il est disposé entre les sous-zones (16, 18) de premiers motifs (32) auxiliaires en des emplacements autres que des deuxièmes motifs (60) auxiliaires,
et/ou **en ce que** les troisièmes motifs (80) auxiliaires sont disposés en d'autres emplacements, de préférence plus près du bord du système (10) de réserve que les premiers motifs (20) auxiliaires et que les deuxièmes motifs (50) auxiliaires.

4. Système (10) de réserve suivant l'une des revendications précédentes, **caractérisé en ce que** des premiers motifs (20) auxiliaires sont disposés près des coins de l'une des sous-zones (16), de préférence au moins un premier motif (20) auxiliaire est disposé près de chaque coin de l'une des sous-zones (16) et/ou **en ce que** des deuxièmes motifs (50) auxiliaires sont disposés près de coins de l'autre sous-zone (18), de préférence au moins un deuxième motif (50) auxiliaire est disposé près de chaque coin de l'autre sous-zone (18),
et/ou **en ce que** des troisièmes motifs (80) auxiliaires sont disposés près des coins d'une zone totale formée par les sous-zones (16, 18), de préférence au moins un troisième motif (80) auxiliaire est disposé près de chaque coin de la zone totale.

5. Système (10) de réserve suivant l'une des revendications précédentes, **caractérisé en ce qu'**un motif (20) auxiliaire comporte au moins un repère (20) d'alignement qui rend possible l'alignement du système (10) de réserve et d'une configuration de circuit intégré, de préférence un repère (20) d'alignement qui comporte au moins une croix ou de préférence un repère (20) d'alignement qui comporte plusieurs structures rectilignes disposées parallèlement entre elles,
et/ou **en ce qu'**un modèle (30) auxiliaire comporte au moins un repère (30) de chevauchement qui rend possible un contrôle du décalage d'une exposition à un rayonnement réalisé à l'aide du système (10) de réserve, de préférence un repère (30) de chevauchement qui comporte au moins un cadre ou au moins une surface rectangulaire ou carrée.

6. Système (10) de réserve suivant l'une des revendications précédentes, **caractérisé par** au moins un premier motif (40) de test pour la production d'une configuration de circuit de test en même temps que l'une des configurations (A) du circuit,
et par au moins un deuxième motif (70) de test pour la production d'une configuration de circuit de test en même temps que l'autre configuration (B) de circuit,
et/ou par au moins un troisième motif (100) de test pour la production d'une configuration de circuit de test en même que les deux autres configurations (A, B) de circuits.

7. Système (10) de réserve suivant la revendication 6, **caractérisé en ce que** de premiers motifs (20, 30) auxiliaires et de premiers motifs (40) de test forment un cadre (46) tout autour de l'une des sous-zones (16),
et **en ce que** des deuxièmes motifs (50) auxiliaires et des deuxièmes motifs (70) de test forment un autre cadre (76) autour de l'autre sous-zone (18),
et/ou **en ce que** des troisièmes motifs (80) auxiliaires et des troisièmes motifs (100) de test forment un autre cadre (108) autour des deux cadres (46, 76).

8. Système (10) de réserve suivant l'une des revendications précédentes, **caractérisé en ce que** le système (10) de réserve est une réserve pour une exposition 1:1, notamment dans un graveur à répétition ou un balayeur de tranche.

9. Système (10) de réserve suivant l'une des revendications précédentes, **caractérisé en ce qu'**il est disposé dans une sous-zone (16,18) des motifs lithographiques pour plusieurs configurations (A) de circuits ayant des câblages différents les uns des autres de composants.

10. Système (10) de réserve suivant l'une des revendications précédentes, **caractérisé par** des motifs de remplissage entre la première sous-zone (16) et la deuxième sous-zone (18),
dans lequel de préférence un premier cadre (110) de motifs de remplissage entoure la première sous-zone (16) et de préférence les premiers motifs (20) auxiliaires et de préférence le premier motif de test,
et dans lequel de préférence un deuxième cadre (112) de motifs de remplissage entoure la deuxième sous-zone (18) et de préférence les deuxièmes motifs (50) auxiliaires et de préférence les deuxièmes motifs de test.

11. Mémoire électronique contenant un jeu de données dont les données fixent la position des motifs d'un système (10) de réserve suivant l'une des revendications précédentes.

12. Programme informatique qui, lorsqu'il est exécuté sur un ordinateur, fixe la position de motifs d'un système (10) de réserve suivant l'une des revendications 1 à 10, ayant notamment une fonction de rassemblement d'une première sous-zone (16) et de motifs (10) auxiliaires appartenant à la première sous-zone (16) en un premier bloc et de rassemblement d'une deuxième sous-zone (18) et de motifs (50) auxiliaire appartenant à la deuxième sous-zone (18) en un autre bloc.

13. Procédé de production de configurations (A, B) de circuits intégrés, notamment en utilisant un système (150) suivant l'une des revendications (1 à 10) comprenant les stades exécutés sans limitation par la succession indiquée :
préparation d'un système (150) de réserve qui comporte au moins deux sous-zones (160, 170) ayant des motifs pour, respectivement, au moins une configuration (A, B) de circuit intégré utile, les configurations de circuits utiles se distinguant de circuits de test par le fait que les configurations de circuits utiles sont utilisées ultérieurement par les utilisateurs d'un produit, tandis que les circuits de test sont inessentiels pour l'utilisateur du produit,
et dans lequel, dans les sous-zones (18), sont disposés des motifs lithographiques pour des configurations (A, B) de circuits intégrés ayant des câblages différents les uns des autres de composants ;
sélection d'une sous-zone (160) pour une exposition à un rayonnement et soustraction de l'autre sous-zone (170) à l'exposition au rayonnement ;
exposition au moins une fois ou plusieurs fois à un rayonnement d'un substrat (260) de finition revêtu d'une réserve et transfert du modèle de la sous-zone (160) sélectionnée à la couche de réserve sans transfert du modèle de l'autre sous-zone (170) à la couche de réserve.

14. Procédé suivant la revendication 13, **caractérisé par** les stades :
sélection de l'autre sous-zone (170) pour une exposition à un rayonnement et soustraction de l'une des sous-zones (160) à l'exposition au rayonnement,
exposition au moins une fois ou plusieurs fois à un rayonnement d'un autre substrat de finition revêtu d'une réserve et transfert du modèle de la sous-zone (170) sélectionnée à la couche de réserve sans transfert du modèle de l'une des sous-zones (160) à la couche de réserve.

15. Procédé suivant la revendication 13 ou 14, **caractérisé par** les stades :
introduction du système (150) de réserve dans une installation d'exposition à un rayonnement et introduction de l'un des substrats (260) de finition dans l'installation d'exposition à un rayonnement avant l'exposition à un rayonnement et de préférence enlèvement du système (150) de réserve de l'installation d'exposition à un rayonnement, notamment avant une nouvelle introduction du système (150) de réserve et notamment avant l'introduction de l'autre substrat de finition.

16. Procédé suivant l'une des revendications 12 à 15, **caractérisé par** les stades réalisés notamment avant l'introduction et/ou l'exposition à un rayonnement du substrat (260) de finition :
introduction du système (10) de réserve et d'un substrat (210) de préparation de finition revêtu d'une réserve dans une installation d'exposition à un rayonnement,
exposition à un rayonnement du substrat (210) de préparation de finition et transfert des modèles des deux sous-zones (16, 18) à la couche de réserve du substrat (210) de préparation de finition.
